# EUROPEAN PATENT APPLICATION

(11) **EP 4 195 295 A1**
(43) Date of publication of application: **14.06.2023**
(21) Application number: 21865748.4
(22) Date of filing: 05.08.2021
(51) Int. Cl.: H01L 31/0224, H01L 31/042

(54) **SOLAR BATTERY METAL ELECTRODE STRUCTURE AND BATTERY ASSEMBLY**

(30) Priority: 08.09.2020 CN 202021942580 U
(71) Applicant: Risen Energy Co. Ltd, Ningbo Zhejiang 315600 (CN)
(72) Inventor: CUI, Yanfeng, Ningbo, Zhejiang 315600 (CN)
(74) Representative: Petraz, Gilberto Luigi
(86) International application number: PCT/CN2021/110867
(87) International publication number: WO 2022/052692

(57) **Abstract**

A metal electrode structure for a solar battery and a battery assembly are provided. The structure of the metal electrode for the solar battery includes multiple main grid lines (1) provided parallel to one another and multiple fine grid lines (2) perpendicular to the main grid lines (1). Spacing between adjacent two main grid lines (1) is defined as *L,* and a distance between two end points of each fine grid line (2) is less than *L.* And connecting ends of adjacent two fine grid lines (2) of the multiple fine grid lines between adjacent two main grid lines (1) are connected to different main grid lines (1) of the adjacent two main grid lines (1).

## Description

### CROSS-REFERENCE TO RELATED APPLICATIONS

This application claims priority to Chinese patent application No. 202021942580.3, filed on September 8, 2020, and titled "SOLAR BATTERY METAL ELECTRODE STRUCTURE AND BATTERY ASSEMBLY". The contents of the above identified applications are hereby incorporated herein in their entireties by reference.

### TECHNICAL FIELD

The present invention relates to the field of solar photovoltaic technology, and in particular, to a solar battery metal electrode structure and a battery assembly.

### BACKGROUND

In a solar battery, metal electrodes are a very important part of the battery structure and have been under constant optimization. The main role of the electrodes is to minimize a lateral transmission resistance of photo-generated current, that is, to improve an efficiency of collecting the photo-generated carriers and thus to improve a photoelectric conversion efficiency of solar batteries. Therefore, the design of a metal electrode pattern is particularly important. A shading area of the electrode and a collection efficiency of carrier are important in the design of the metal electrode pattern. In order to collect as many photo-generated carriers as possible and reduce the lateral transmission resistance, spacing between adjacent metal electrodes can be reduced, which means that the number of electrodes needs to be increased or the width of a single electrode should be increased. However, the shading area of the electrode may be increased and a light receiving area of the battery may be reduced, resulting in low battery conversion efficiency. At the same time, an increase of the number of electrodes will also increase the amount of metallic silver paste, leading to more cost. On the contrary, when the spacing between adjacent metal electrodes are wide and the number of electrodes is small, it is conducive to reducing the shading area of the electrode and increasing the light receiving area. Since the number of electrodes is small, the amount of silver paste is reduced, which helps to reduce the cost. However, this will make the transverse transmission resistance increase, which affects the filling factor of the battery, and then affects the conversion efficiency of the battery. Therefore, the design of metal electrode patterns should be balanced between the two aspects.

Currently, the method for producing the metal electrodes used in the photovoltaic industry is screen printing technology. A structure of the metal electrode usually contains interlocking parallel metal grid lines, i.e., main grid lines and fine grid lines. The fine grid lines are parallel to each other, and a certain spacing is defined between adjacent two fine grid lines and the number of the fine grid lines is large. The main grid lines are perpendicular to the fine grid lines. Spacing between adjacent two main grid lines is relatively wide, and the number of the main grid lines is small, which has developed from the initial 3 busbars (3BB) to the current 5 busbars (5BB), 9 busbars (9BB) and 12 busbars (12BB). The fine grid lines are mainly used to collect photo-generated carriers, and the main grid lines collect and output the carriers collected by the. In order to improve the collection efficiency, the main grid lines and fine grid lines are usually interleaved to reduce the contact resistance at the same time. However, the above design has a large shading area on the one hand, and high silver paste consumption on the other hand, resulting in low battery conversion efficiency and high production cost. Moreover, a height of the interlaced main grid lines and fine grid lines is higher than the surrounding area, which can easily cause battery breakage and hidden cracks when subjected to external force.

### SUMMARY

In order to overcome the defects of the conventional art, the present invention provides a metal electrode structure of a solar battery, and a battery assembly, which have high photoelectric conversion efficiency and low silver paste consumption. The electrode structure can lower risks of battery breakage and hidden cracks.

In order to solve the technical problems above, the present invention provides the following technical solution.

A metal electrode structure of a solar battery, includes a plurality of main grid lines parallel to each other, and a plurality of fine grid lines disposed perpendicular to the plurality of main grid lines. Spacing between adjacent two of the plurality of main grid lines is defined as L, and the distance between two end points of each of the plurality of fine grid line is less than L. Connecting ends of adjacent two of the plurality of fine grid lines between adjacent two of the plurality of main grid lines are located on different main grid lines, respectively.

Furthermore, the distance between two end points of each of the plurality of fine grid lines is greater than or equal to *0.75L.*

Furthermore, the plurality of main grid lines and the plurality of fine grid lines are straight lines or wavy lines.

Furthermore, the plurality of main grid lines are provided with hollow sections.

Furthermore, the plurality of main grid lines are regarded as a Multi-Busbar, the number of the plurality of main grid lines is defined as *M,* and *M* is smaller than or equal to 50 and greater than or equal to 2.

Furthermore, *L* is in a range of 1 millimeter to 50 millimeters.

Furthermore, spacing between adjacent two of the plurality of fine grid lines is in a range of 1 millimeter to 5 millimeters.

Furthermore, a width of each of the plurality of main grid lines is in a range of 1 micrometer to 5 millimeters; and a width of each of the plurality of fine grid lines is in a range of 1 micrometer to 100 micrometers.

A battery assembly includes a plurality of battery pieces. The plurality of battery pieces includes the metal electrode structure described above.

The technical solution of the present invention has the following beneficial effects.

In a metal electrode structure of a solar battery of the present invention, since the plurality of main grid lines and the plurality of fine grid lines are interlace with each other, and a length of the fine grid line is less than spacing *L* between adjacent two main grid lines, a length of the metal grid electrode can be reduced without effecting a lateral transmission resistance of carriers and collection of the carriers by the metal grid electrode. Therefore, a consumption of the silver paste, and a cost of the production can be reduced, a shading area can reduced, and a conversion efficiency of the battery can be improved. In the present invention, by optimizing a design of a conjunction between the fine grid line and the main grid line, a risk of hidden cracks of the battery can be reduced, and a reliability of the battery assembly can be improved.

In the metal electrode structure of the present invention, by decreasing a length of the fine grid lines, at least 15% of the shading area can be reduced, and at least 10% of the silver paste consumption can be saved, and the conversion efficiency of the battery can be improved.

### BRIEF DESCRIPTION OF THE DRAWINGS

FIG. 1 is a schematic diagram of a metal electrode structure of a solar battery of a first embodiment of the present invention.
FIG. 2 is a partial structural schematic diagram of a metal electrode structure of a solar battery in the present invention.

In the figures, 1 represents a main grid line, and 2 represents a fine grid line.

### DETAILED DESCRIPTION

The following embodiments provide a more complete understanding of the present invention for the skilled in the art, but they are not a limitation on the scope of protection of the present invention. By "an embodiment" or "embodiment" herein is meant a particular feature, structure, or characteristic that may be included in at least one embodiment of the present invention. The phrase "in an embodiment" appearing in various places in the present specification does not mean the same embodiment, nor is it a separate or selective embodiment that is mutually exclusive with other embodiments

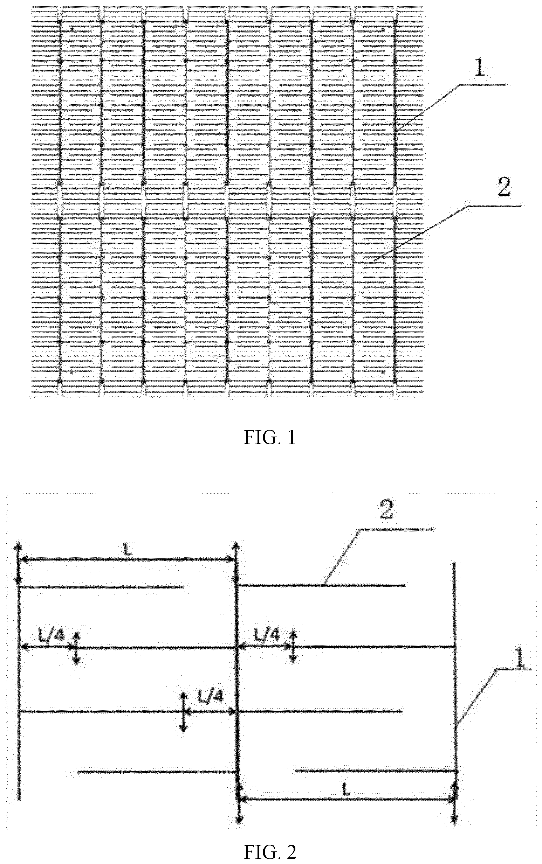

Referring to FIG.1 and FIG. 2, the present invention provides a metal electrode structure of a solar battery. The metal electrode structure includes a plurality of main grid lines 1 parallel to each other, and a plurality of fine grid lines 2 disposed perpendicular to the main grid lines. A spacing between adjacent two main grid lines 1 is defined as *L,* and a distance between two end points of each of the plurality of fine grid line 2 is less than *L.* Connecting ends of adjacent two fine grid lines 2 of the plurality of fine grid lines 2 between adjacent two main grid lines 1 are connected to different main grid lines 1 of the adjacent two main grid lines 1. The plurality of fine grid lines can be segmented lines in parallel with each other. The plurality of fine grid lines 2 can define staggered fine grid lines 2, so as to ensure collection of photo-generated carriers. The electrode structure of the present invention optimize a connection between the fine grid lines and the main grid lines (that is, both ends of the fine grid lines 2 are perpendicularly connected to the main grid lines 1, respectively) in the conventional art, which overcomes problems of a large shading area, a low photoelectric conversion efficiency, and high silver paste consumption.

In some embodiments of the present invention, the distance between two end points of each of the plurality of fine grid lines 2 can be greater than or equal to *0.75L.* Since the distance between the two end points of each of the plurality of fine grid lines are controlled in the range of *0.75L* to *L,* not only the collection of the photo-generated carrier can be guaranteed, but also the silver paste consumption can be controlled in a suitable area to effectively control the production cost. When the linear distance between the two end points of each of the plurality of fine grid lines is less than *0.75L,* the collection of the photo-generated carrier may be influenced, so as to lower the photoelectric conversion efficiency in some degree.

In some embodiments, the number of the plurality of main grid lines 1 is defined as *M* (MBB, multiple Busbar), and *M* is smaller than or equal to 50 and greater than or equal to 2. In some embodiments, the number of the plurality of main grid lines can be 5, 9, 12, and the like, according to actual need.

In some embodiments, *L* can be in a range of 1 millimeter to 50 millimeters. In some embodiments, *L* can be selected from 1 millimeter, 2 millimeters, 5 millimeters, 6 millimeters, 8 millimeters, 10 millimeters, 12 millimeters, 15 millimeters, 18 millimeters, 20 millimeters, 25 millimeters, 30 millimeters, 35 millimeters, 40 millimeters, 45 millimeters, 48 millimeters or 50 millimeters. By designing the spacing between adjacent two main grid lines in the range of 1 millimeter to 50 millimeters, the number of the main grid lines is suitable, the number of the fine grid lines disposed between the main grid lines is also suitable, and the shading area is suitable, so that the photoelectric conversion efficiency can be effectively improved.

In some embodiments, a spacing between adjacent two fine grid lines of the plurality of fine grid lines can be in a range of 1 millimeter to 5 millimeters. In some embodiments, the spacing between adjacent two fine grid lines can be selected from 1 millimeter, 1.2 millimeters, 1.5 millimeters, 1.8 millimeters, 2 millimeters, 2.5 millimeters, 2.8 millimeters, 3 millimeters, 3.2 millimeters, 3.5 millimeters, 3.8 millimeters, 4 millimeters, 4.2 millimeters, 4.5 millimeters, 4.8 millimeters or 5 millimeters. By controlling the spacing between the adjacent two fine grid lines in the range of 1 millimeter to 5 millimeters, the shading area is suitable, the lateral transmission resistance of the photo-generated carriers is small, and the photoelectric conversion efficiency is high. By designing the spacing between adjacent two main grid lines in the range of 1 millimeter to 50 millimeters, the shading area is suitable, the lateral transmission resistance of the photo-generated carriers is small, and the photoelectric conversion efficiency is high. When the spacing between the adjacent two fine grid lines is less than 1 millimeter, the number of the electrodes may significantly increases. Therefore, the shading area may be surely increased, and a light receiving area of the battery may be decreased, leading to low conversion efficiency of the battery, increase silver paste consumption, and increase of the production cost. When the spacing between the adjacent two fine grid lines is greater than 5 millimeters, the lateral transmission resistance may increase, which may influence a filling factor of the battery, thereby influencing the conversion efficiency of the battery.

In some embodiments, a width of each of the plurality of main grid lines can be in a range of 1 micrometer to 5 millimeters. When the width of each of the plurality of main grid lines is in a range of 1 micrometer to 5 millimeters, the shading area is suitable, the photoelectric conversion efficiency is high, the silver paste consumption is low and the production cost is low. In some embodiment, the width of each of the plurality of main grid lines can be selected from 1 micrometer, 2 micrometers, 3 micrometers, 4 micrometers, 5 micrometers, 6 micrometers, 8 micrometers, 10 micrometers, 20 micrometers, 50 micrometers, 80 micrometers, 100 micrometers, 0.5 millimeters, 1 millimeter, 1.5 millimeters, 2 millimeters, 2.5 millimeters, 3 millimeters, 3.5 millimeters, 4 millimeters, 4.5 millimeters, or 5 millimeters.

In some embodiments, a width of each of the plurality of fine grid lines can be in a range of 1 micrometer to 100 micrometers. In some embodiments, the width of each of the plurality of fine grid lines can be selected from 1 micrometer, 2 micrometers, 3 micrometers, 4 micrometers, 5 micrometers, 6 micrometers, 7 micrometers, 8 micrometers, 10 micrometers, 15 micrometers, 20 micrometers, 25 micrometers, 30 micrometers, 35 micrometers, 40 micrometers, 45 micrometers, 50 micrometers, 55 micrometers, 60 micrometers, 65 micrometers, 70 micrometers, 75 micrometers, 80 micrometers, 85 micrometers, 90 micrometers, 95 micrometers, 100 micrometers. When the width of each of the plurality of fine grid lines is in the range of 1 micrometer to 100 micrometers, the shading area is suitable, the photoelectric conversion efficiency is high, the silver paste consumption is low and the production cost is low.

In some embodiments, of the present invention, the plurality of main grid lines can be provided with hollow sections. In this way, the silver paste consumption can be further lowered on the premise that the photoelectric conversion efficiency is ensured. The specific ratio of a length or an area of the hollow section to those of the main grid line 1 are not limited, which can be limited according to actual manufacturing technique.

In some embodiments of the present invention, the plurality of main grid lines 1 and the plurality of fine grid lines 2 can be selected from at least one of straight lines or wavy lines. For example, both the plurality of main grid lines 1 and the plurality of fine grid lines 2 are wavy lines; optionally, the plurality of main grid lines 1 are linear lines, and the plurality of fine grid lines 2 are wavy lines.

The present invention further provides a battery assembly. The battery assembly can include a plurality of battery pieces, which includes the metal electrode structure described above.

### First embodiment

In the present embodiment, the number of the plurality of main grid lines was 9. A spacing between the plurality of main grid lines was *L.* A length of a fine grid line was *0.75L. L* was 16.79 millimeters. A spacing between adjacent two fine grid lines of the plurality of fine grid lines was 1.99 millimeters. A width of the main grid line was 0.13 millimeters. A width of the fine grid line was 50 micrometers. Both the main grid lines and the fine grid lines were linear lines.

### Second embodiment

In the present embodiment, a length of the fine grid line was 0.8L, and the other structures of the metal electrodes were the same as those of the metal electrodes in the first embodiment.

### Third embodiment

In the present embodiment, a length of the fine grid line was 0.83L, and the other structures of the metal electrodes were the same as those of the metal electrodes in the first embodiment.

### Fourth embodiment

In the present embodiment, a length of the fine grid line was 0.86L, and the other structures of the metal electrodes were the same as those of the metal electrodes in the first embodiment.

### Fifth embodiment

In the present embodiment, the main grid lines were provided with hollow sections (not shown in the figures). A distance between two end points of fine grid lines being perpendicularly connected to the hollow sections of the plurality of fine grid lines was *0.75L.* The other structures of the metal electrodes were the same as those of the metal electrodes in the first embodiment.

### Sixth embodiment

In the present invention, the main grid lines were provided with fish spear-shaped hollow section. A distance between two end points of fine grid lines being perpendicularly connected to the hollow sections of the plurality of fine grid lines was *L.* The other structures of the metal electrodes were the same as those of the metal electrodes in the first embodiment.

### Seventh embodiment

In the present embodiment, a distance between two end points of fine grid lines being perpendicularly connected to the hollow sections of the plurality of fine grid lines was *L,* and the other structures of the metal electrodes were the same as those of the metal electrodes in the second embodiment.

### Comparative embodiment

In comparative embodiments, both ends of the fine grid lines were perpendicularly connected to the main grid lines, respectively. The other structures of the metal electrodes were the same as those of the metal electrodes in the first embodiment.

The battery pieces of the present embodiment and the battery pieces in conventional art were tested, short-circuit currents (ISC), voltages of open circuit (VOC) of the battery piece of the present embodiment were obtained, and the filling factor (FF) and the conversion efficiency (Eff) were calculated. The specific values were shown in Table 1.

**Table 1 Performances and silver paste consumption of battery pieces in the conventional art and the first embodiment**

| | The number of battery pieces (pcs) | I_{sc} (A) | V_{oc} (V) | FF (%) | Eff (%) | Silver paste consumption of the fine grid lines on a front surface of the battery (g) | Reduction of silver paste (%) |
|---|---|---|---|---|---|---|---|
| Comparative embodiment | 50 | 9.53061 | 0.74606 | 82.6129 | 23.31 | 0.0505 | / |
| First embodiment | 50 | 9.57161 | 0.74743 | 82.18 | 23.33 | 0.044 | 12.87% |

Referring to Table 1, compared with the electrode having a conventional structure, the conversion efficiency of the electrode structure of the present invention was improved, and the silver paste consumption was lowered for 12.87%.

It could be concluded from carriers transmission calculation that by decreasing lengths of the fine grid lines 2 in the metal electrode structure of the solar battery in the first embodiment to the seventh embodiment, the shading area was decreased for at least 15%, the silver paste consumption was decreased for at least 10%, and the conversion efficiency of the battery was increased.

In view of above, in the metal electrode structure of a solar battery in the present invention, since the main grid lines and the fine grid lines are interlaced, and a length of the fine grid line in a range of *0.75L* to *L* (a spacing between adjacent two main grid lines is defined as *L*), the length of the metal grid electrode could be reduced without influencing lateral transmission of the carriers and collection of the carriers by the metal grid electrode. Therefore, not only the silver paste consumption is lowered, but also the shading area is decreased, thereby increasing the conversion efficiency of the battery and lowering the production cost. At the same time, in the present invention, by optimizing the conjunction between the fine grid lines and the main grid lines, a risk of hidden cracks of the battery can be reduced, and a reliability of the battery assembly can be improved.

Taking the above-mentioned ideal embodiments based on the present invention as an inspiration, the above description allows the skilled in the art to make various changes and modifications without deviating from the technical idea of the present invention. Any modification, equivalent substitution, improvement, etc. made within the spirit and principles of the present invention shall be included in the scope of protection of the present invention. The technical scope of the invention is not limited to the contents of the specification, but must be determined according to the scope of the claims.

## Claims

1. A metal electrode structure of a solar battery, **characterized by** comprising a plurality of main grid lines parallel to each other, and a plurality of fine grid lines disposed perpendicular to the plurality of main grid lines,
spacing between adjacent two of the plurality of main grid lines is defined as *L,* and a distance between two end points of each of the plurality of fine grid lines is less than *L,* and
connecting ends of adjacent two of the plurality of fine grid lines between adjacent two of the plurality of main grid lines are located on different main grid lines, respectively.

2. The metal electrode structure of the solar battery of claim 1, wherein the distance between two end points of each of the plurality of fine grid lines is greater than or equal to *0.75L.*

3. The metal electrode structure of the solar battery of claim 1, wherein the plurality of main grid lines and the plurality of fine grid lines are selected from at least one of straight lines or wavy lines.

4. The metal electrode structure of the solar battery of claim 1, wherein the plurality of main grid lines are provided with hollow sections.

5. The metal electrode structure of the solar battery of claim 1, wherein the plurality of main grid lines are regarded as a Multi-Busbar, the number of the plurality of main grid lines is defined as *M,* and *M* is smaller than or equal to 50 and greater than or equal to 2.

6. The metal electrode structure of the solar battery of claim 1, wherein *L* is in a range of 1 millimeter to 50 millimeters.

7. The metal electrode structure of the solar battery of claim 1, wherein spacing between adjacent two of the plurality of fine grid lines is in a range of 1 millimeter to 5 millimeters.

8. The metal electrode structure of the solar battery of claim 1, wherein a width of each of the plurality of main grid lines is in a range of 1 micrometer to 5 millimeters; and a width of each of the plurality of fine grid lines is in a range of 1 micrometer to 100 micrometers.

9. A battery assembly, **characterized by** comprising a plurality of battery pieces in electric connection with each other, wherein the plurality of battery pieces comprises the metal electrode structure of any one of claims 1 to 8.
